# EUROPEAN PATENT APPLICATION

(11) **EP 4 383 981 A1**
(43) Date of publication of application: **12.06.2024**
(21) Application number: 23211181.5
(22) Date of filing: 21.11.2023
(51) Int. Cl.: H10B 43/27, H01L 23/00

(54) **SEMICONDUCTOR DEVICES AND DATA STORAGE SYSTEMS INCLUDING THE SAME**

(30) Priority: 28.11.2022 KR 20220161590
(71) Applicant: Samsung Electronics Co., Ltd., Suwon-si, Gyeonggi-do 16677 (KR)
(72) Inventor: KIM, Jaeho, 16677 Suwon-si, Gyeonggi-do (KR); YANG, Woosung, 16677 Suwon-si, Gyeonggi-do (KR); KWON, Joonyoung, 16677 Suwon-si, Gyeonggi-do (KR); KIM, Jiyoung, 16677 Suwon-si, Gyeonggi-do (KR); SUNG, Sukkang, 16677 Suwon-si, Gyeonggi-do (KR)
(74) Representative: Kuhnen & Wacker Patent- und Rechtsanwaltsbüro PartG mbB

(57) **Abstract**

A semiconductor device includes a first substrate structure (S1) including a substrate (201), circuit elements (220) on the substrate (201), a first interconnection structure (270, 280) on the circuit elements (220), and first metal bonding layers (298) on the first interconnection structure (270, 280); and a second substrate structure (S2) connected to the first substrate structure (S 1), and the second substrate structure (S2) includes: a plating layer (101); gate electrodes (130) stacked and spaced apart from each other in a first direction below the plating layer (101); channel structures (CH) penetrating through the gate electrodes (130) and extending in the first direction; a separation region (MS) penetrating through the gate electrodes (130) and extending in a second direction (X); a second interconnection structure (150, 155, 170, 180) below the gate electrodes (130) and the channel structures (CH); second metal bonding layers (198) below the second interconnection structure (150, 155, 170, 180) and connected to the first metal bonding layers (298); and dummy pattern layers (160) between the second metal bonding layers (198), extending in the second direction (X), and including an insulating material.

## Description

### BACKGROUND

### 1. Field

The present disclosure relates to semiconductor devices and data storage systems including the same.

### 2. Description of the Related Art

In a data storage system requiring data storage, a semiconductor device that can store high-capacity data is required. Accordingly, a method for increasing data storage capacity of a semiconductor device has been researched. For example, as one of the methods for increasing data storage capacity of a semiconductor device, a semiconductor device including three-dimensionally arranged memory cells, instead of two-dimensionally arranged memory cells, has been proposed.

### SUMMARY

According to an aspect of the present disclosure, a semiconductor device may include: a first substrate structure including a substrate, circuit elements on the substrate, a first interconnection structure on the circuit elements, and first metal bonding layers on the first interconnection structure; and a second substrate structure connected to the first substrate structure on the first substrate structure, and the second substrate structure may include: a plating layer; gate electrodes stacked and spaced apart from each other in a first direction perpendicular to a lower surface of the plating layer below the plating layer; channel structures penetrating through the gate electrodes and extending in the first direction, and each including a channel layer; a separation region penetrating through the gate electrodes and extending in a second direction perpendicular to the first direction; a second interconnection structure below the gate electrodes and the channel structures; second metal bonding layers below the second interconnection structure and connected to the first metal bonding layers; and dummy pattern layers between the second metal bonding layers, extending in the second direction, and including an insulating material.

According to an aspect of the present disclosure, a semiconductor device may include: a first substrate structure including a substrate, circuit elements on the substrate, and first metal bonding layers on the circuit elements; and a second substrate structure connected to the first substrate structure on the first substrate structure, and the second substrate structure may include: a plating layer; gate electrodes stacked and spaced apart from each other in a first direction perpendicular to a lower surface of the plating layer below the plating layer; channel structures penetrating through the gate electrodes and extending in the first direction, and each including a channel layer; a separation region penetrating through the gate electrodes and extending in a second direction perpendicular to the first direction; second metal bonding layers below the gate electrodes and the channel structures and connected to the first metal bonding layers; and dummy pattern layers between the second metal bonding layers and including an insulating material, wherein the second metal bonding layers may have a first thickness, and the dummy pattern layers may have a second thickness, greater than the first thickness.

According to an aspect of the present disclosure, a data storage system may include: a semiconductor storage device including a first substrate structure including circuit elements and first metal bonding layers, a second substrate structure including gate electrodes and second metal bonding layers connected to the first metal bonding layers, and an input/output pad electrically connected to the circuit elements; and a controller electrically connected to the semiconductor storage device through the input/output pad and configured to control the semiconductor storage device, and the semiconductor storage device may further include dummy pattern layers in at least one of a region between the first metal bonding layers and a region between the second metal bonding layers and including different materials from a material of the first metal bonding layers and a material of the second metal bonding layers.

### BRIEF DESCRIPTION OF DRAWINGS

Features will become apparent to those of skill in the art by describing in detail exemplary embodiments with reference to the attached drawings, in which:
FIG. 1 is a schematic cross-sectional view of a semiconductor device according to example embodiments of the present disclosure;
FIG. 2 is a partially enlarged view of a semiconductor device according to example embodiments of the present disclosure;
FIG. 3 is a partial perspective view of a semiconductor device according to example embodiments of the present disclosure;
FIGS. 4A and 4B are a schematic cross-sectional view and a partially enlarged view of a semiconductor device according to example embodiments of the present disclosure;
FIGS. 5A and 5B are a schematic cross-sectional view and a partially enlarged view of a semiconductor device according to example embodiments of the present disclosure;
FIGS. 6A and 6B are schematic cross-sectional views of a semiconductor device according to example embodiments of the present disclosure;
FIGS. 7A and 7B are schematic cross-sectional views of a semiconductor device according to example embodiments of the present disclosure;
FIGS. 8A to 8I are cross-sectional views of stages in a method of manufacturing a semiconductor device according to example embodiments of the present disclosure;
FIG. 9 is a view schematically illustrating a data storage system including a semiconductor device according to example embodiments of the present disclosure;
FIG. 10 is a perspective view schematically illustrating a data storage system including a semiconductor device according to an example embodiment; and
FIG. 11 is a cross-sectional view schematically illustrating a semiconductor package according to an example embodiment.

### DETAILED DESCRIPTION

Hereinafter, example embodiments of the present disclosure will be described with reference to the accompanying drawings. Hereinafter, it may be understood that expressions such as "on," "above," "upper," "below," "beneath," "lower," and "side," are merely indicated as shown in the drawings, except where indicated and referred to separately in the specification. In the claims, the terms "upper", "lower", "higher" and "below" may relate to a vertical direction from one side of the claimed semiconductor device (lower side) to another side (upper side) of the claimed semiconductor device, wherein the lower side is opposite the upper side in the vertical direction.

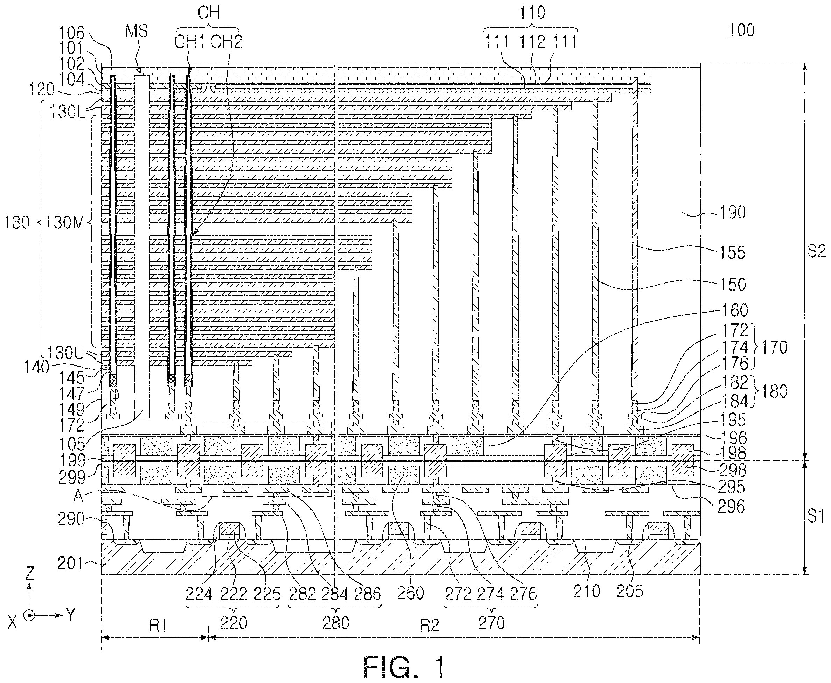

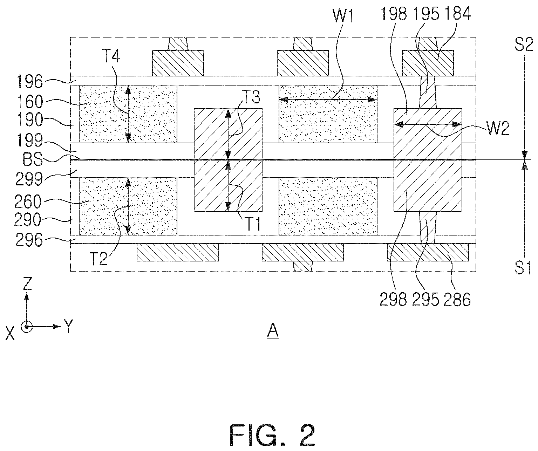

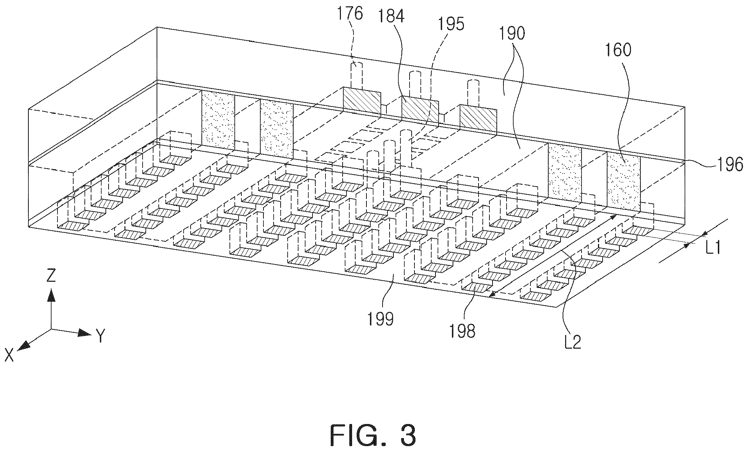

FIG. 1 is a schematic cross-sectional view of a semiconductor device according to example embodiments of the present disclosure. FIG. 2 is an enlarged view of region 'A' in FIG. 1. FIG. 3 is a partial perspective view of a semiconductor device according to example embodiments of the present disclosure.

Referring to FIGS. 1 to 3, a semiconductor device 100 may include first and second substrate structures S1 and S2 that are vertically bonded to each other. The first substrate structure S1 may include a peripheral circuit region, and the second substrate structure S2 may include a memory cell region.

The first substrate structure S1 may include a substrate 201, source/drain regions 205 and element isolation layers 210 in the substrate 201, circuit elements 220 disposed on the substrate 201, a peripheral region insulating layer 290, a lower protective layer 296, circuit contact plugs 270, circuit interconnection lines 280, first bonding vias 295, first metal bonding layers 298, a first bonding insulating layer 299, and first dummy pattern layers 260.

The substrate 201 may have an upper surface extending in the X-direction and the Y-direction. The element isolation layers 210 may be formed on the substrate 201 to define an active region. The source/drain regions 205 including impurities may be disposed in a portion of the active region. The substrate 201 may include a semiconductor material, e.g., a group IV semiconductor, a group III-V compound semiconductor, or a group II-VI compound semiconductor. For example, the substrate 201 may be provided as a single crystal bulk wafer.

The circuit elements 220 may include a planar transistor. Each of the circuit elements 220 may include a circuit gate dielectric layer 222, spacer layers 224, and a circuit gate electrode 225. The source/drain regions 205 may be disposed in the substrate 201 on opposite sides of the circuit gate electrode 225.

The peripheral region insulating layer 290 may be disposed on the circuit element 220 on the substrate 201. The peripheral region insulating layer 290 may include a plurality of insulating layers formed in different process operations. The peripheral region insulating layer 290 may be made of an insulating material.

The lower protective layer 296 may be disposed on upper surfaces of third circuit interconnection lines 286 and extend horizontally. In example embodiments, the lower protective layer 296 may be further disposed on upper surfaces of first and second circuit interconnection lines 282 and 284. The lower protective layer 296 may be a layer for preventing contamination of components disposed upward due to a metallic material of the circuit interconnection lines 280 disposed downward. The lower protective layer 296 may be formed of an insulating material different from the peripheral region insulating layer 290, e.g., silicon nitride.

The circuit contact plugs 270 and the circuit interconnection lines 280 may constitute a first interconnection structure of the first substrate structure S1. The circuit contact plugs 270 may include first to third circuit contact plugs 272, 274 and 276. The circuit contact plugs 270 have a cylindrical shape and may be connected to the source/drain regions 205 by penetrating through the peripheral region insulating layer 290. An electrical signal may be applied to the circuit element 220 by the circuit contact plugs 270. In a region not illustrated, the circuit contact plugs 270 may be connected to the circuit gate electrode 225. The circuit interconnection lines 280 may include the first to third circuit interconnection lines 282, 284 and 286. The circuit interconnection lines 280 may be connected to the circuit contact plugs 270 and may have a linear shape. The circuit contact plugs 270 and the circuit interconnection lines 280 may include a conductive material, e.g., tungsten (W), copper (Cu), aluminum (Al), and the like, and each of the components may further include a diffusion barrier. However, in example embodiments, the number and arrangement of layers of the circuit contact plugs 270 and the circuit interconnection lines 280 may be variously changed.

The first bonding vias 295, the first metal bonding layers 298, and the first bonding insulating layer 299 constitute a first bonding structure and may be disposed on the third circuit interconnection lines 286. The first bonding vias 295 may have a cylindrical shape, and the first metal bonding layers 298 may have a linear shape. Upper surfaces of the first metal bonding layers 298 may be exposed to an upper surface of the first substrate structure S1, e.g., the upper surfaces of the first metal bonding layers 298 may be coplanar with the upper surface of the first substrate structure S 1. The first bonding vias 295 and the first metal bonding layers 298 may provide an electrical connection path between the first substrate structure S1 and the second substrate structure S2. A portion of the first metal bonding layers 298 may not be connected to the lower circuit interconnection lines 280 and may be disposed only for bonding. The first bonding vias 295 and the first metal bonding layers 298 may include a conductive material, e.g., copper (Cu). The first bonding insulating layer 299 may be disposed around the first metal bonding layers 298. The first bonding insulating layer 299 may also function as a diffusion barrier of the first metal bonding layers 298, and may include, e.g., at least one of SiN, SiON, SiCN, SiOC, SiOCN, and SiO.

The first dummy pattern layers 260 may be disposed between the first metal bonding layers 298 below the first bonding insulating layer 299. The first dummy pattern layers 260 may include an insulating material, and may include a material different from that of the peripheral region insulating layer 290. For example, the first dummy pattern layers 260 may include at least one of SiO, SiN, SiCN, SiOC, SiON, and SiOCN. For example, the first dummy pattern layers 260 may have a linear shape extending in the X-direction that is the same direction as a separation region MS of the second substrate structure S2. As illustrated in FIG. 2, a thickness T2 (or height) of the first dummy pattern layers 260 (e.g., in the Z direction) may be greater than a thickness T1 of the first metal bonding layers 298. A level of upper surfaces of the first dummy pattern layers 260 may be lower than a level of the upper surfaces of the first metal bonding layers 298, e.g., a distance from the upper surfaces of the first dummy pattern layers 260 to the bottom of the substrate 201 may be smaller than a distance from the upper surfaces of the first metal bonding layers 298 to the bottom of the substrate 201. The level of lower surfaces of the first dummy pattern layers 260 may be lower than a level of lower surfaces of the first metal bonding layers 298, e.g., a distance from the lower surfaces of the first dummy pattern layers 260 to the bottom of the substrate 201 may be smaller than a distance from the lower surfaces of the first metal bonding layers 298 to the bottom of the substrate 201.

The second substrate structure S2 may have a first region R1 and a second region R2, and may include a plating layer 101, first and second horizontal conductive layers 102 and 104 on a lower surface of the plating layer 101, gate electrodes 130 stacked on lower surfaces of the first and second horizontal conductive layers 102 and 104, interlayer insulating layers 120 alternately stacked with the gate electrodes 130, a separation region MS extending in one direction by penetrating through the gate electrodes 130, channel structures CH disposed to penetrate through the gate electrodes 130 in the first region R1, and second dummy pattern layers 160. The second substrate structure S2 may further include a passivation layer 106, a horizontal insulating layer 110, cell region insulating layers 190, and an upper protective layer 196. As a second interconnection structure, the second substrate structure S2 may further include gate contacts 150, substrate contacts 155, cell contact plugs 170, and cell interconnection lines 180, connected to the gate electrodes 130 in the second region R2. As a second bonding structure, the second substrate structure S2 may further include second bonding vias 195, second metal bonding layers 198, and a second bonding insulating layer 199.

As the first region R1 of the second substrate structure S2 is a region in which the gate electrodes 130 are vertically stacked and the channel structures CH are disposed, it may be a region in which memory cells are disposed. As the second region R2 of the second substrate structure S2 is a region in which the gate electrodes 130 extend to different lengths and are connected to the gate contacts 150, it may correspond to a region for electrically connecting the memory cells to the first substrate structure S1. The second region R2 may be disposed in at least one end of the first region R1 in at least one direction.

The plating layer 101 may have an upper surface extending in the X-direction and the Y-direction. The plating layer 101 may function as a common source line of the semiconductor device 100. The plating layer 101 may include a conductive material. For example, the plating layer 101 may include a semiconductor material, e.g., a group IV semiconductor, a group III-V compound semiconductor, or a group II-VI compound semiconductor. For example, the group IV semiconductor may include silicon, germanium, or silicon-germanium. The plating layer 101 may further include impurities. The plating layer 101 may be provided as a polycrystalline semiconductor layer, e.g., a polycrystalline silicon layer, or an epitaxial layer.

The first and second horizontal conductive layers 102 and 104 may be sequentially stacked and disposed on a lower surface of the first region R1 of the plating layer 101. The first horizontal conductive layer 102 may not extend to the second region R2 of the plating layer 101, and the second horizontal conductive layer 104 may extend to the second region R2. The first horizontal conductive layer 102 may function as a portion of a common source line of the semiconductor device 100, and, e.g., may function as a common source line along with the plating layer 101. The first horizontal conductive layer 102 may be directly connected to the channel layer 140 around the channel layer 140.

The second horizontal conductive layer 104 may be in contact with the plating layer 101 in regions in which the first horizontal conductive layer 102 and the horizontal insulating layer 110 are not disposed. The second horizontal conductive layer 104 may be bent to cover an end of the first horizontal conductive layer 102 or the horizontal insulating layer 110 in the regions and may extend onto a lower surface of the plating layer 101.

The first and second horizontal conductive layers 102 and 104 may include a semiconductor material, and for example, both the first and second horizontal conductive layers 102 and 104 may include polycrystalline silicon. In this case, at least the first horizontal conductive layer 102 may be a doped layer, and the second horizontal conductive layer 104 may be a doped layer or a layer including impurities diffused from the first horizontal conductive layer 102. In another example, the material of the second horizontal conductive layer 104 may be replaced with an insulating layer. In addition, in some example embodiments, the first and second horizontal conductive layers 102 and 104 and the horizontal insulating layer 110 may be omitted.

The horizontal insulating layer 110 may be disposed on the lower surface of the plating layer 101 at a level of overlapping the first horizontal conductive layer 102 in at least a portion of the second region R2. The horizontal insulating layer 110 may include first and second horizontal insulating layers 111 and 112 alternately stacked on the second region R2 of the plating layer 101. The horizontal insulating layer 110 may be layers remaining after a portion thereof in the process of manufacturing the semiconductor device 100 is replaced with the first horizontal conductive layer 102.

The horizontal insulating layer 110 may include, e.g., silicon oxide, silicon nitride, silicon carbide, or silicon oxynitride. The first horizontal insulating layers 111 and the second horizontal insulating layer 112 may include different insulating materials. For example, the first horizontal insulating layers 111 may be made of the same material as the interlayer insulating layers 120, and the second horizontal insulating layer 112 may be made of a material different from that of the interlayer insulating layers 120.

The gate electrodes 130 may be vertically spaced apart from each other on an upper surface of the plating layer 101 to form a stacked structure together with the interlayer insulating layers 120. For example, the stacked structure may include lower and upper stacked structures vertically stacked on each other and surrounding first and second channel structures CH1 and CH2, respectively. In another example, the stacked structure may be formed of a single stacked structure.

The gate electrodes 130 may include at least one lower gate electrode 130L forming a gate of a ground selection transistor, memory gate electrodes 130M forming a plurality of memory cells, and upper gate electrodes 130U forming gates of string select transistors. Here, the lower and upper stacked structures, the lower gate electrode 130L, and the upper gate electrodes 130U may be referred to as "lower" and "upper" based on a direction during a manufacturing process. The number of memory gate electrodes 130M forming the memory cells may be determined according to the capacity of the semiconductor device 100. According to an example embodiment, each of the upper and lower gate electrodes 130U and 130L may have one to four or more gate electrodes, and may have the same structure as the memory gate electrodes 130M or have a different structure therefrom. In example embodiments, the gate electrodes 130 may further include a gate electrode 130 disposed below the upper gate electrodes 130U and/or on the lower gate electrode 130L and configured to form an erase transistor used for an erase operation using a gate induced drain leakage (GIDL) phenomenon. In addition, some gate electrodes 130, e.g., the memory gate electrodes 130M adjacent to the upper or lower gate electrodes 130U and 130L, may be dummy gate electrodes. The gate electrodes 130 may be disposed to be separated from each other in predetermined units in the Y-direction by the separation region MS.

The gate electrodes 130 may be vertically spaced apart from each other on the first region R1 and the second region R2, and may extend from the first region R1 to the second region R2 to form a stair-shaped step structure in a portion of the second region R2. The gate electrodes 130 may be disposed to have a step structure with each other even in the X-direction. Due to the step structure, the gate electrodes 130 may have regions in which the upper gate electrode 130 extends longer than the lower gate electrode 130 so that lower surfaces thereof are exposed downwardly from the interlayer insulating layers 120 and other gate electrodes 130, and the regions may be referred to as gate pad regions. The gate electrodes 130 may be connected to the gate contacts 150 in the gate pad regions. In some example embodiments, the gate electrodes 130 may have an increased thickness in the gate pad regions.

The gate electrodes 130 may include a metallic material, e.g., tungsten (W). According to an example embodiment, the gate electrodes 130 may include polycrystalline silicon or a metal silicide material. In example embodiments, the gate electrodes 130 may further include a diffusion barrier, and, the diffusion barrier may include, e.g., tungsten nitride (WN), tantalum nitride (TaN), titanium nitride (TiN), or combinations thereof.

The interlayer insulating layers 120 may be disposed between the gate electrodes 130. Like the gate electrodes 130, the interlayer insulating layers 120 may be spaced apart from each other in a direction perpendicular to the lower surface of the plating layer 101 and may extend in the Y-direction. The interlayer insulating layers 120 may include an insulating material, e.g., silicon oxide or silicon nitride.

The separation region MS may be disposed to penetrate through the gate electrodes 130 and extend in the X-direction. Although only one separation region MS is illustrated in FIG. 1, a plurality of separation regions MS may extend in the X-direction parallel to each other and may be spaced apart from each other in the Y-direction. The separation region MS may penetrate through all the gate electrodes 130 stacked on the plating layer 101 and may be connected to the plating layer 101.

For example, the separation region MS may have a shape in which a width thereof decreases toward the plating layer 101 due to a high aspect ratio. The separation region MS may include a separation insulating layer 105. The separation insulating layer 105 may include an insulating material, e.g., silicon oxide, silicon nitride, or silicon oxynitride. In example embodiments, the separation region MS may further include a conductive layer.

Each of the channel structures CH forms one memory cell string, and may be spaced apart from each other while forming rows and columns on the lower surface of the plating layer 101 in the first region R1. The channel structures CH may be disposed to form a grid pattern or may be disposed in a zigzag shape in one direction. The channel structures CH have a pillar shape, and may have side surfaces inclined so that a width thereof becomes narrower as they are closer to the plating layer 101 according to the aspect ratio. In example embodiments, some of the channel structures CH may be dummy channels that do not substantially form a memory cell string, and for example, some of the channel structures CH disposed adjacent to the second area R2 may be dummy channels.

Each of the channel structures CH may have a shape in which the first and second channel structures CH1 and CH2 penetrating through lower and upper stacked structures of the gate electrodes 130, respectively, are connected to each other, and may have a bent portion due to a difference or change in width in a connection region. However, according to example embodiments, the number of channel structures stacked along a Z-direction may be variously changed.

Each of the channel structures CH may include a channel layer 140, a gate dielectric layer 145, a channel buried insulating layer 147, and a channel pad 149 disposed in a channel hole. For example, the channel layer 140 may be formed in an annular shape surrounding the channel buried insulating layer 147 therein. In another example, the channel layer 140 may have a pillar shape, e.g., a cylinder or a prism, without the channel buried insulating layer 147. The channel layer 140 may be connected to the first horizontal conductive layer 102 at a lower portion thereof. The channel layer 140 may include a semiconductor material, e.g., a polycrystalline silicon or single crystalline silicon. In some example embodiments, when the first and second horizontal conductive layers 102 and 104 are omitted, the channel layer 140 may be exposed through an upper end thereof and directly connected to the plating layer 101.

The gate dielectric layer 145 may be disposed between the gate electrodes 130 and the channel layer 140. Although not illustrated in detail, the gate dielectric layer 145 may include a tunneling layer, a charge storage layer, and a blocking layer sequentially stacked from the channel layer 140. The tunneling layer may tunnel charges to the charge storage layer, and may include, e.g., silicon oxide (SiO₂), silicon nitride (Si₃N₄), silicon oxynitride (SiON), or combinations thereof. The charge storage layer may be a charge trap layer or a floating gate conductive layer. The blocking layer may include ,e.g., silicon oxide (SiO₂), silicon nitride (Si₃N₄), silicon oxynitride (SiON), a high-κ dielectric material, or combinations thereof. In example embodiments, at least a portion of the gate dielectric layer 145 may extend in a horizontal direction along the gate electrodes 130.

The channel pad 149 may be disposed only in a lower end of the second channel structure CH2 at a lower portion. The channel pads 149 may include, e.g., doped polycrystalline silicon.

The channel layer 140, the gate dielectric layer 145, and the channel buried insulating layer 147 may be connected to each other between the first channel structure CH1 and the second channel structure CH2. An interlayer insulating layer 120 having a relatively thick thickness may be further disposed between the first channel structure CH1 and the second channel structure CH2. However, the shapes of the interlayer insulating layers 120 may be variously changed in example embodiments.

The cell region insulating layer 190 may be disposed to cover the lower surface of the plating layer 101 and the gate electrodes 130 on the lower surface of the plating layer 101. The passivation layer 106 may be disposed on the upper surface of the plating layer 101. The passivation layer 106 may function as a layer protecting the semiconductor device 100. The cell region insulating layer 190 and the passivation layer 106 may include an insulating material, e.g., at least one of silicon oxide, silicon nitride, and silicon carbide, and may include a plurality of insulating layers according to example embodiments.

The upper protective layer 196 may be disposed on lower surfaces of second cell interconnection lines 184 in the cell region insulating layer 190 and may extend horizontally. In example embodiments, the upper protective layer 196 may be further disposed on lower surfaces of first cell interconnection lines 182. The upper protective layer 196 may be a layer for preventing contamination of components disposed at the top due to a metallic material of the cell interconnection lines 180 disposed at the bottom, during a manufacturing process. The upper protective layer 196 may be formed of an insulating material different from that of the peripheral region insulating layer 290, e.g., silicon nitride.

The second interconnection structure may include the gate contacts 150, the substrate contact 155, the cell contact plugs 170, and the cell interconnection lines 180, and the second substrate structure S2 may be electrically connected to the first substrate structure S1.

The gate contacts 150 may penetrate through the cell region insulating layer 190 and may be connected to the gate electrodes 130. The substrate contact 155 may be connected to the plating layer 101.

The cell contact plugs 170 may include first to third cell contact plugs 172, 174 and 176, and the cell interconnection lines 180 may include the first and second cell interconnection lines 182 and 184. The channel pads 149, the gate contacts 150, and the substrate contact 155 may be connected to the first cell contact plugs 172 at a lower end. The first cell contact plugs 172 may be connected to the second cell contact plugs 174 at the lower end, and the second cell contact plugs 174 may be connected to the first cell interconnection lines 182 at the lower end. The third cell contact plugs 176 may vertically connect the first and second cell interconnection lines 182 and 184. The cell contact plugs 170 may have a cylindrical shape. The cell contact plugs 170 may have different lengths. For example, the first cell contact plugs 172 may have a relatively long length. In example embodiments, the cell contact plugs 170 may have side surfaces inclined so that a width thereof is narrowed toward the plating layer 101 and the width thereof increases toward the first substrate structure S1, according to the aspect ratio. According to example embodiments, some of the cell contact plugs 170 may be dummy contact plugs to which an electrical signal is not applied.

The first cell interconnection lines 182 may include bit lines of the first region R1 connected to the channel structures CH and interconnection lines of the second region R2 disposed at the same height level as that of the bit lines. The second cell interconnection lines 184 may be interconnection lines disposed below the first cell interconnection lines 182. The cell interconnection lines 180 may have a linear shape extending in at least one direction. In example embodiments, the second cell interconnection lines 184 may have a thickness thicker than that of the first cell interconnection lines 182. The cell interconnection lines 180 may have side surfaces inclined so that the width is narrowed toward the plating layer 101.

The gate contacts 150, the substrate contacts 155, the cell contact plugs 170, and the cell interconnection lines 180 may include, e.g., tungsten (W), aluminum (Al), copper (Cu), tungsten nitride (WN), tantalum nitride (TaN), titanium nitride (TiN), or combinations thereof.

The second bonding vias 195 of the second bonding structure may be disposed below the second cell interconnection lines 184 and may be connected to the second cell interconnection lines 184, and the second metal bonding layers 198 of the second bonding structure may be connected to the second bonding vias 195. Lower surfaces of the second metal bonding layers 198 may be exposed as a lower surface of the second substrate structure S2, e.g., the surfaces of the second metal bonding layers 198 may be coplanar with the lower surface of the second substrate structure S2. The second metal bonding layers 198 may be bonded (e.g., directly bonded) and connected (e.g., directly connected) to the first metal bonding layers 298 of the first substrate structure S1, and the second bonding insulating layer 199 may be bonded (e.g., directly bonded) and connected (e.g., directly connected) to the first bonding insulating layer 299 of the first substrate structure S 1. The second bonding vias 195 and the second metal bonding layers 198 may include a conductive material, e.g., copper (Cu). The second bonding insulating layer 199 may include, e.g., at least one of SiO, SiN, SiCN, SiOC, SiON, and SiOCN.

The first and second substrate structures S1 and S2 may be bonded by, e.g., directly, bonding the first metal bonding layers 298 and the second metal bonding layers 198 to each other, and by , e.g., directly, bonding the first bonding insulating layer 299 and the second bonding insulating layer 199 to each other. The bonding of the first metal bonding layers 298 and the second metal bonding layers 198 may be, e.g., copper (Cu)-to-copper (Cu) bonding, and the bonding of the first bonding insulating layer 299 and the second bonding insulating layer 199 may be, e.g., dielectric-to-dielectric bonding (e.g., SiCN-to-SiCN bonding). The first and second substrate structures S1 and S2 may be bonded by hybrid bonding including copper (Cu)-to-copper (Cu) bonding and dielectric-to-dielectric bonding.

The second dummy pattern layers 160 may be disposed between at least some of the second metal bonding layers 198 on the second bonding insulating layer 199. The second dummy pattern layers 160 may be disposed to be horizontally spaced apart from the second metal bonding layers 198, e.g., one second dummy pattern layer 160 may be between two adjacent second metal bonding layers 198 and horizontally spaced apart from each of the adjacent second metal bonding layers 198. Upper surfaces of the second dummy pattern layers 160 may be in, e.g., direct, contact with the upper protective layer 196 and may be covered (e.g., completely covered and overlapped) with the upper protective layer 196. Lower surfaces of the second dummy pattern layers 160 may be in, e.g., direct, contact with the second bonding insulating layer 199 and may be covered (e.g., completely covered and overlapped) with the second bonding insulating layer 199. Side surfaces of the second dummy pattern layers 160 may be in, e.g., direct, contact with the cell region insulating layer 190. In an example embodiment of the present disclosure, the second dummy pattern layers 160 may be disposed below the second interconnection structure, i.e., below the second cell interconnection lines 184 (e.g., so the second dummy pattern layers 160 may be between the second cell interconnection lines 184 and the first substrate structure S1).

The second dummy pattern layers 160 may be stress relief layers for improving warpage of the semiconductor device 100. During the manufacturing process of the second substrate structure S2, warpage may potentially occur in the second substrate structure S2 due to high temperature processes and patterns of the channel structures CH and the separation region MS formed on the lower surface of the plating layer 101. For example, before the second dummy pattern layers 160 are formed, the second substrate structure S2 may be subjected to tensile stress due to the gate electrodes 130, and in this case, the warpage may potentially occur in the second substrate structure S2 including the plating layer 101. For example, with reference to FIG. 1, an edge in an X-axis of the second substrate structure S2 could be potentially warped downwardly, and an edge in a Y-axis may be potentially lifted upwardly, thereby causing a horse saddle-shaped warpage.

In contrast, since the second dummy pattern layers 160 are made of a compressive stress material, the warpage may be offset or alleviated. That is, the second dummy pattern layers 160 may have a linear shape extending in the X-direction (i.e., same as an arrangement direction of the channel structures CH and an extension direction of the separation region MS). Accordingly, the warpage of the second substrate structure S2 may be efficiently reduced. In addition, it is possible to prevent defects occurring when the second substrate structure S2 is bonded to the first substrate structure S1 in a warpage state.

For example, as illustrated in FIG. 2, a first width W1 of the second dummy pattern layers 160 in the Y-direction may be wider than a second width W2 of the second metal bonding layers 198 in the Y-direction. For example, the first width W1 may be in the range of about 200 nm to about 1000 nm. However, the first width W1 may be variously changed according to a height and a material of the second dummy pattern layers 160. A thickness T4 (or height) of the second dummy pattern layers 160 may be greater than a thickness T3 of the second metal bonding layers 198. For example, the thickness T4 may be in the range of about 400 nm to about 1400 nm.

The second dummy pattern layers 160 may overlap a portion of the second metal bonding layers 198 in a horizontal direction (the X-direction and/or the Y-direction). For example, the second dummy pattern layers 160 may be disposed at a level overlapping some regions of the second metal bonding layers 198 in the horizontal direction, e.g., portions of facing sidewalls of the second dummy pattern layers 160 and the second metal bonding layers 198 may overlap each other. The second dummy pattern layers 160 may be disposed at a level overlapping at least a portion of the second bonding vias 195 in a horizontal direction (the X-direction and/or the Y-direction). The level of the upper surfaces of the second dummy pattern layers 160 may be higher than the level of the upper surfaces of the second metal bonding layers 198, e.g., a distance from the upper surfaces of the second dummy pattern layers 160 to the bottom of the substrate 201 may be larger than a distance from the upper surfaces of the second metal bonding layers 198 to the bottom of the substrate 201. The level of the lower surfaces of the second dummy pattern layers 160 may be higher than the level of the lower surfaces of the second metal bonding layers 198, e.g., a distance from the lower surfaces of the second dummy pattern layers 160 to the bottom of the substrate 201 may be larger than a distance from the lower surfaces of the second metal bonding layers 198 to the bottom of the substrate 201.

As illustrated in FIG. 3, the second metal bonding layers 198 may be arranged by forming rows and columns in the X-direction and the Y-direction (e.g., as viewed in a plan view). The second dummy pattern layers 160 may be arranged in a linear shape so as to extend in the X-direction between rows of the second metal bonding layers 198 in the X-direction, e.g., one second dummy pattern layer 160 may extend continuously along an entire row of the second metal bonding layers 198. For example, the second dummy pattern layers 160 need not be disposed between all rows of the second metal bonding layers 198 in the X-direction, e.g., the second dummy pattern layers 160 may be disposed between at least some of the rows. In the X-direction, a length L1 of each of the second metal bonding layers 198 may be shorter than a length L2 of each of the second dummy pattern layers 160.

The second dummy pattern layers 160 may include an insulating material. The second dummy pattern layers 160 may be formed of a material applying stress in a direction different from that of the gate electrodes 130. The second dummy pattern layers 160 may include, e.g., at least one of SiN, SiON, SiCN, SiOC, SiOCN, and SiO. For example, since the second dummy pattern layers 160 include an insulating material, the second dummy pattern layers 160 may not cause electrical defects such as a bridge or short with the second interconnection structure or the second bonding structure, unlike a case of including a conductive material. The second dummy pattern layers 160 may include a material different from each of the gate electrodes 130, the first metal bonding layers 298, the second metal bonding layers 198, and the cell region insulating layer 190. In some example embodiments, the second dummy pattern layers 160 may include the same material as the upper protective layer 196. In this case, a boundary between the upper surfaces of the second dummy pattern layers 160 and the upper protective layer 196 may not be distinguished. In some example embodiments, the second dummy pattern layers 160 may include the same material as the second bonding insulating layer 199.

Referring back to FIG. 2, the second dummy pattern layers 160 may be disposed symmetrically with the first dummy pattern layers 260 based on a bonding surface BS of the first substrate structure S1 and the second substrate structure S2, e.g., the second dummy pattern layers 160 and the first dummy pattern layers 260 may be vertically symmetrical to each other with respect to the bonding surface BS between the first and second substrate structures S1 and S2. Accordingly, the above-mentioned descriptions of the second dummy pattern layers 160 may be identically applied to the first dummy pattern layers 260. In example embodiment of the present disclosure, at least some of the second dummy pattern layers 160 may be disposed to correspond to each other in the Z-direction with the first dummy pattern layers 260.

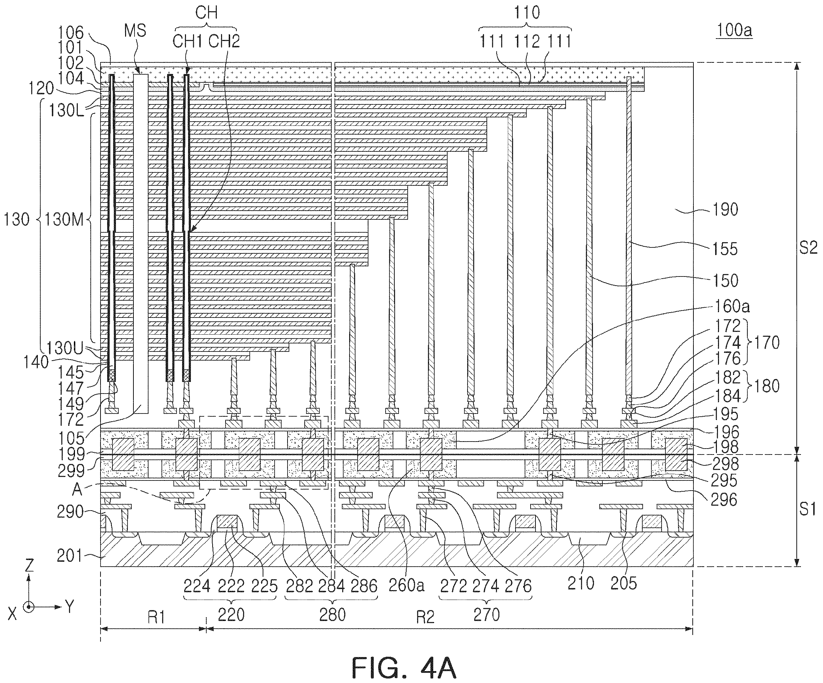

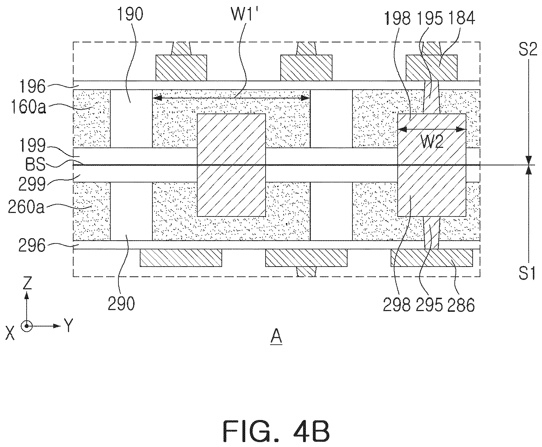

FIG. 4A is a schematic cross-sectional view of a semiconductor device according to example embodiments of the present disclosure. FIG. 4B is an enlarged view of region 'A' of FIG. 4A.

Referring to FIGS. 4A and 4B, in a semiconductor device 100a, a second dummy pattern layers 160a may be disposed to come into, e.g., direct, contact with the second metal bonding layers 198. In detail, at least some of the second dummy pattern layers 160a may extend onto an upper surface of the second metal bonding layer 198, and may be disposed to surround a portion of the upper surface and side surfaces of the second metal bonding layer 198. In an example embodiment of the present disclosure, a first width W1' of the second dummy pattern layers 160a in the Y-direction may be wider than the second width W2 of the second metal bonding layers 198 in the Y-direction. Similarly, at least some of first dummy pattern layers 260a may be disposed to surround a portion of the lower surface and side surfaces of the first metal bonding layer 298.

Since the first dummy pattern layers 260a and the second dummy pattern layers 160a are made of an insulating material as described above, they may not affect an electrical path in the semiconductor device 100a. Accordingly, in example embodiments, an arrangement relationship between the second dummy pattern layers 160a and the second metal bonding layers 198 and an arrangement relationship between the first dummy pattern layers 260a and the first metal bonding layers 298 may be variously changed.

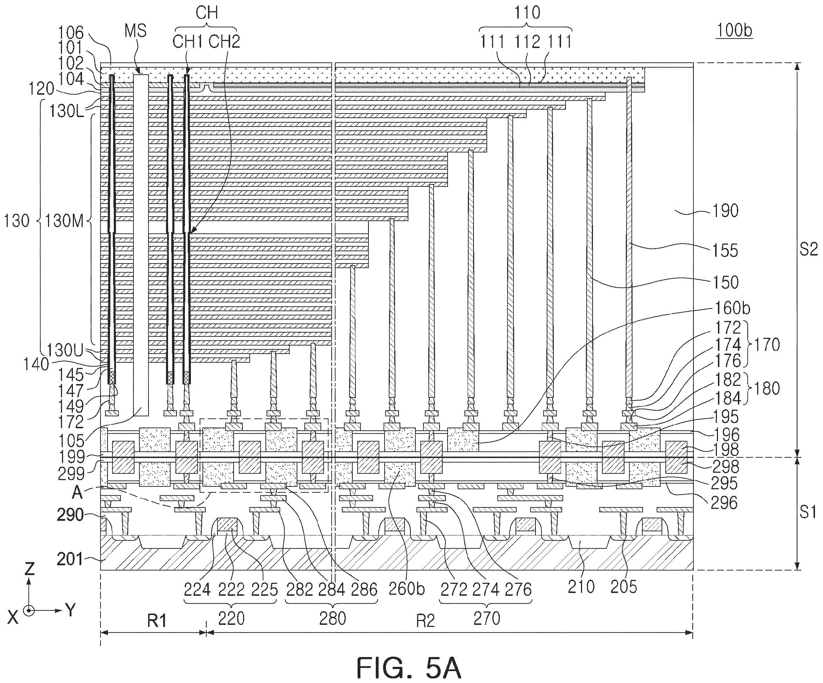

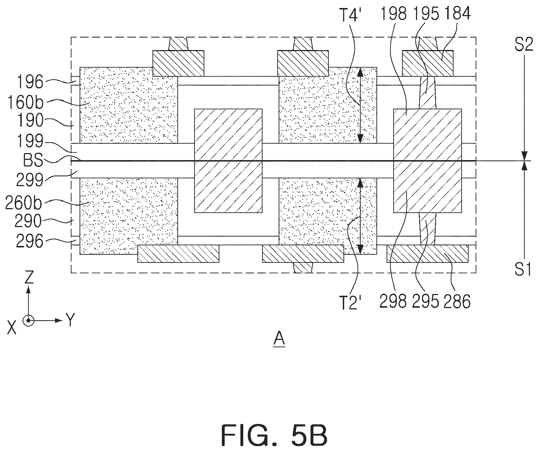

FIG. 5A is a schematic cross-sectional view of a semiconductor device according to example embodiments of the present disclosure. FIG. 5B is an enlarged view of region 'A' of FIG. 5A.

Referring to FIGS. 5A and 5B, in a semiconductor device 100b, a thickness T2' of the first dummy pattern layers 260b and a thickness T4' of the second dummy pattern layers 160b may be relatively wider than those of the embodiment of FIG. 2. Upper surfaces of the second dummy pattern layers 160b may be disposed at a higher level than a lower surface of the second interconnection structure. In detail, the upper surfaces of the second dummy pattern layers 160b may be disposed at a higher level than lower surfaces of the second cell interconnection lines 184 disposed at a lowest portion of the second interconnection structure, e.g., relative to the bottom of the substrate 201. Accordingly, the second dummy pattern layers 160b may be in contact with the second cell interconnection lines 184 through side surfaces thereof. Similarly, the lower surfaces of the first dummy pattern layers 260b may be disposed at a lower level (e.g., relative to the bottom of the substrate 201) than an upper surface of the first interconnection structure, e.g., upper surfaces of the third circuit interconnection lines 286.

Since the first dummy pattern layers 260b and the second dummy pattern layers 160b are made of an insulating material as described above, they may not affect an electrical path in the semiconductor device 100b. Accordingly, in example embodiments, depths of the first dummy pattern layers 260b and the second dummy pattern layers 160b from the bonding surface BS may be variously changed. In some example embodiments, the present embodiment may be combined with the embodiments of FIGS. 4A and 4B, and combinations of the embodiments may be variously performed.

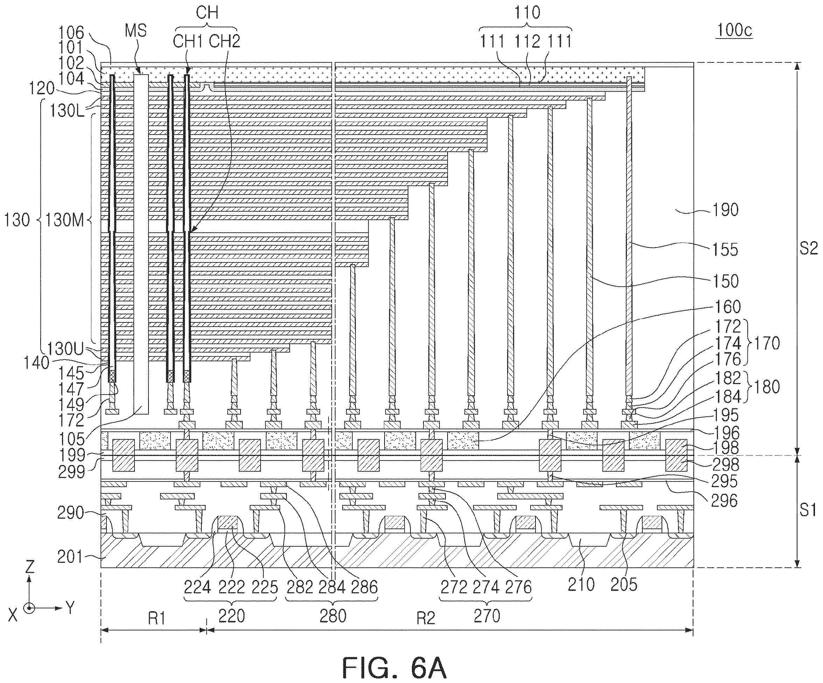

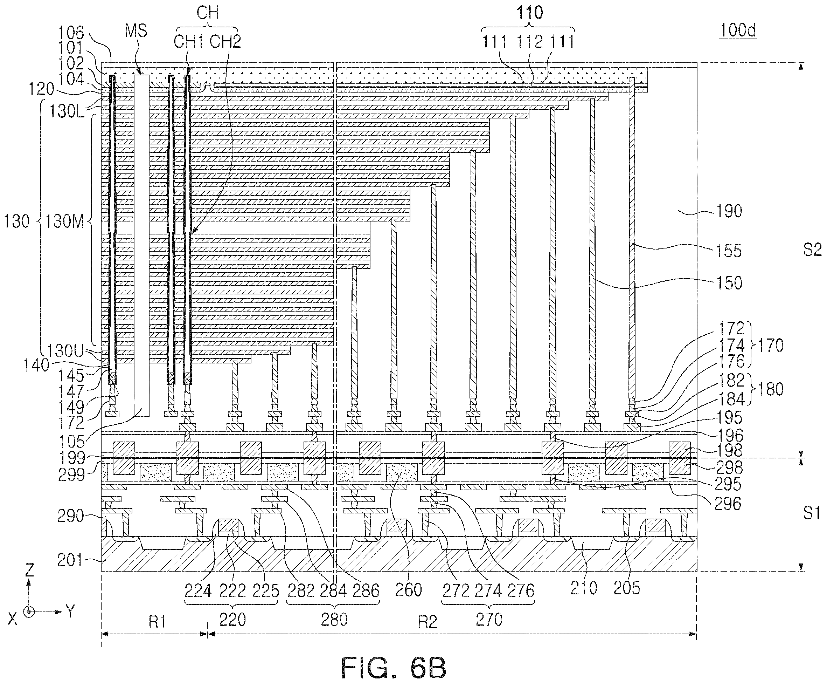

FIGS. 6A and 6B are schematic cross-sectional views of a semiconductor device according to example embodiments of the present disclosure.

Referring to FIG. 6A, in a semiconductor device 100c, the first substrate structure S1 may not include the first dummy pattern layers 260, and only the second substrate structure S2 may include the second dummy pattern layers 160. Since the above-described warpage mainly occurs in the second substrate structure S2, when the warpage may be compensated by the second dummy pattern layers 160, dummy pattern layers may be disposed only in the second substrate structure S2. Although the second dummy pattern layers 160 are illustrated as having the same shape as illustrated in the embodiment of FIGS. 1 to 3, the second dummy pattern layers 160 are not limited thereto, e.g., the second dummy pattern layers 160 be disposed in the form of the embodiments of FIGS. 4A to 5B.

Referring to FIG. 6B, in a semiconductor device 100d, the second substrate structure S2 may not include the second dummy pattern layers 160, and only the first substrate structure S1 may include the first dummy pattern layers 260. The above-described warpage mainly occurs in the second substrate structure S2, but when the warpage may be compensated by the first dummy pattern layers 260, dummy pattern layers may be disposed only in the first substrate structure S1 in this manner. Although the first dummy pattern layers 260 are illustrated in the same form as illustrated the embodiment of FIGS. 1 to 3, the first dummy pattern layers 260 are not limited thereto, e.g., the first dummy pattern layers 260 may be disposed in the form of the embodiments of FIGS. 4A to 5B.

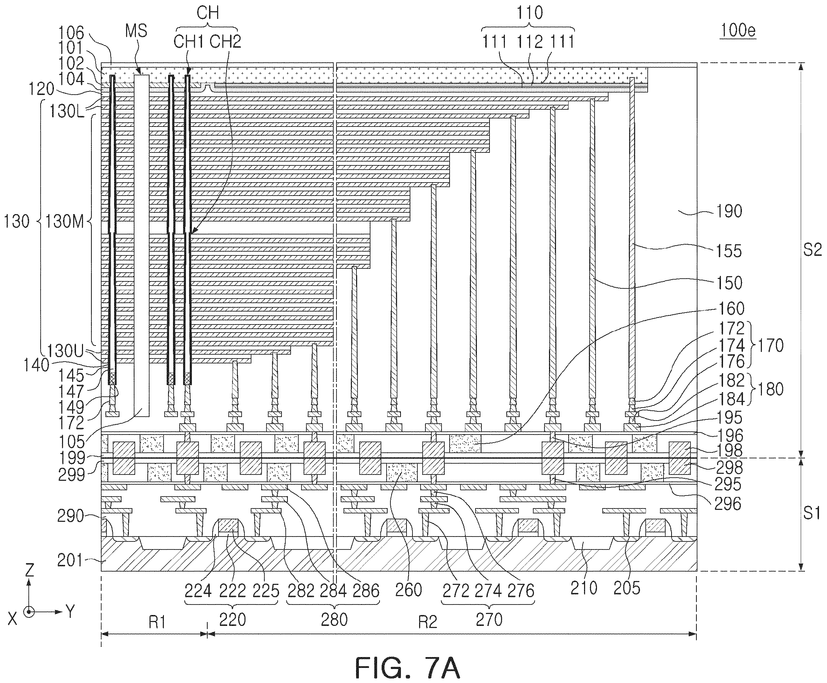

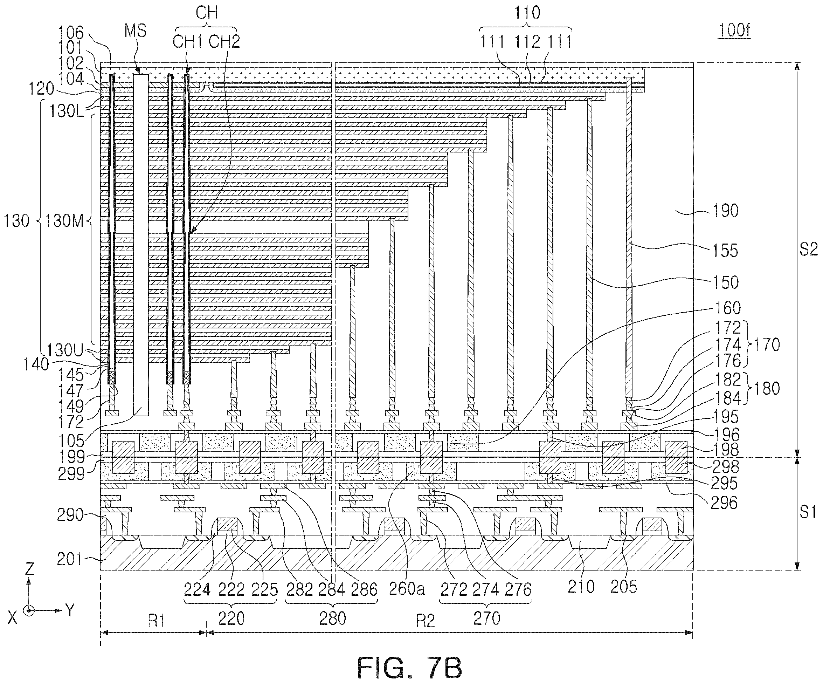

FIGS. 7A and 7B are schematic cross-sectional views of a semiconductor device according to example embodiments of the present disclosure.

Referring to FIG. 7A, in a semiconductor device 100e, at least a portion of the first dummy pattern layers 260 and the second dummy pattern layers 160 may be asymmetrically disposed with each other based on a boundary between bonding surfaces of the first and second substrate structures S1 and S2. For example, at least some of the second dummy pattern layers 160 may not overlap the first dummy pattern layers 260 in the Z-direction.

Referring to FIG. 7B, in a semiconductor device 100f, at least a portion of the first dummy pattern layers 260a and the second dummy pattern layers 160 may be asymmetrically disposed with each other based on the boundary between bonding surfaces of the first and second substrate structures S1 and S2, and may be simultaneously disposed in different shapes. Specifically, at least a portion of the first dummy pattern layers 260a may be disposed to surround a portion of lower surfaces and side surfaces of each of the first metal bonding layers 298 as in the embodiments of FIGS. 4A and 4B. Unlike the first dummy pattern layers 260a, at least a portion of the second dummy pattern layers 160 may be disposed to be horizontally spaced apart from the second metal bonding layers 198, as in the embodiments of FIGS. 1 and 2.

In the above-described embodiments, the arrangements of the first dummy pattern layers 260, 260a and 260b and the second dummy pattern layers 160, 160a and 160b of the above-described embodiments may be variously combined.

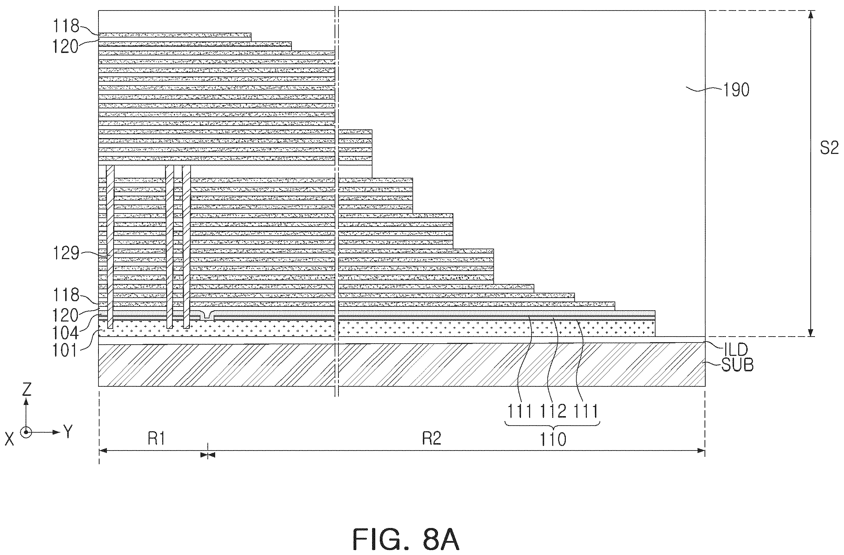

FIGS. 8A to 8I are cross-sectional views schematically illustrating stages in a method of manufacturing a semiconductor device according to example embodiments of the present disclosure.

Referring to FIG. 8A, a manufacturing process of the second substrate structure S2 may be initiated. First, an intermediate insulating layer ILD may be formed on a base substrate SUB, a plating layer 101, a horizontal insulating layer 110 and a second horizontal conductive layer 104 may be formed thereover, sacrificial insulating layers 118 and interlayer insulating layers 120 may be alternately stacked on each other, and channel sacrificial layers 129 may be then formed.

The base substrate SUB is a layer removed through a subsequent process and may be a semiconductor substrate, e.g., silicon (Si). The intermediate insulating layer ILD may be formed to protect the plating layer 101 when the base substrate SUB is subsequently removed. The plating layer 101 may be formed of, e.g., a polycrystalline silicon layer.

The horizontal insulating layer 110 may be formed by alternately stacking first and second horizontal insulating layers 111 and 112 on the plating layer 101. The horizontal insulating layer 110 may be a layer replaced with the first horizontal conductive layer 102 of FIG. 1 through a subsequent process in the first region R1. The first horizontal insulating layers 111 may include a material different from that of the second horizontal insulating layer 112. For example, the first horizontal insulating layers 111 may be made of the same material as the interlayer insulating layers 120, and the second horizontal insulating layer 112 may be made of the same material as the sacrificial insulating layers 118.

The second horizontal conductive layer 104 may be formed on the horizontal insulating layer 110 and may be in contact with the plating layer 101 in a region from which the horizontal insulating layer 110 is removed. Accordingly, the second horizontal conductive layer 104 may be bent along ends of the horizontal insulating layer 110 and may cover the ends thereof and extend onto the plating layer 101.

Next, in order to form the lower stacked structure, the sacrificial insulating layers 118 and the interlayer insulating layers 120 may be alternately stacked on each other in a region where the first channel structures CH1 (see FIG. 1) are disposed. The sacrificial insulating layers 118 may be layers replaced with the gate electrodes 130 (see FIG. 1) through a subsequent process. The sacrificial insulating layers 118 may be formed of a material that may be etched with an etching selectivity with respect to the interlayer insulating layers 120. For example, the interlayer insulating layer 120 may be made of at least one of silicon oxide and silicon nitride, and the sacrificial insulating layers 118 may be made of a material different from that of the interlayer insulating layer 120, e.g., silicon, silicon oxide, silicon carbide, and silicon nitride. In example embodiments, a thickness of the interlayer insulating layers 120 and the number of layers provided therein may be variously changed from the illustrated constitutions.

Next, photolithography and etching processes for the sacrificial insulating layers 118 and the interlayer insulating layers 120 may be repeated so that the upper sacrificial insulating layers 118 extend shorter than the lower sacrificial insulating layers 118 in the second region R2. Accordingly, the sacrificial insulating layers 118 may be formed to be stair-shaped. In example embodiments, the sacrificial insulating layers 118 may be formed so as to have a relatively thick thickness at ends thereof, and a process for this may be further performed. Next, a portion of the cell region insulating layer 190 for covering the sacrificial insulating layers 118 and the lower stacked structure of the interlayer insulating layers 120 may be formed.

The channel sacrificial layers 129 may be formed by forming lower channel holes to penetrate through the lower stacked structure in a region corresponding to the first channel structures CH1, and depositing a material of the channel sacrificial layers 129 on the lower channel holes. The channel sacrificial layers 129 may include, e.g., polycrystalline silicon.

The upper stacked structure may be formed on the lower stacked structure in the same manner as the lower stacked structure. Next, upper channel holes may be formed in a region corresponding to the second channel structures CH2 (see Fig. 1) to penetrate through the upper stacked structure, and channel sacrificial layers may be further formed.

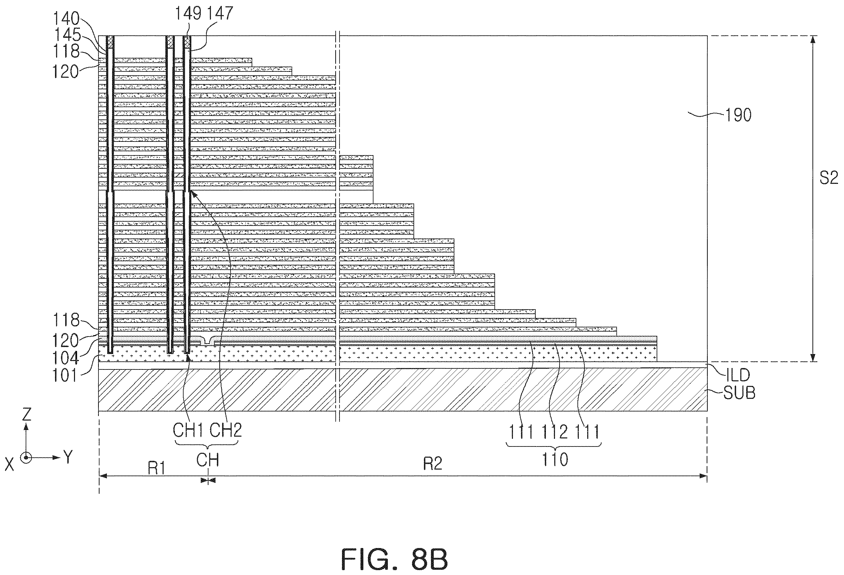

Referring to FIG. 8B, channel structures CH penetrating through the stacked structure of the sacrificial insulating layers 118 and the interlayer insulating layers 120 may be formed.

First, channel holes may be formed by removing the channel sacrificial layers 129. Next, the gate dielectric layer 145, the channel layer 140, the channel buried insulating layer 147, and the channel pad 149 may be sequentially formed in each of the channel holes, thus forming the channel structures CH including the first and second channel structures CH1 and CH2. The channel layer 140 may be formed on the gate dielectric layer 145 in the channel structures CH. The channel buried insulating layer 147 may be formed to fill the channel structures CH and may be an insulating material. However, according to example embodiments, a space between the channel layers 140 may be filled with a conductive material other than the channel buried insulating layer 147. The channel pads 149 may be made of the conductive material, e.g., polycrystalline silicon.

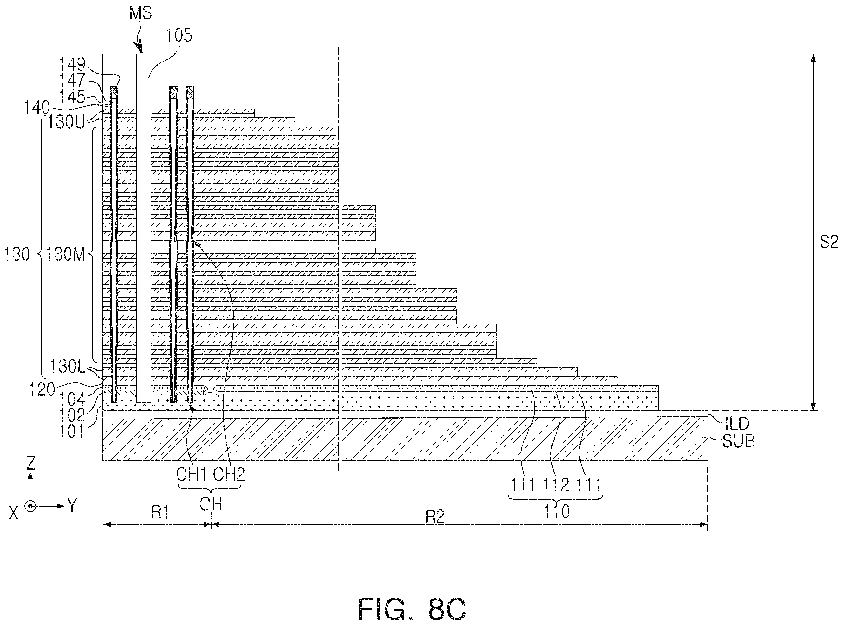

Referring to FIG. 8C, after forming an opening, the first horizontal conductive layer 102 may be formed, the sacrificial insulating layers 118 may be removed through the opening, and gate electrodes 130 may be formed.

First, the opening may be formed in a region corresponding to the separation region MS, and may be formed in a trench shape extending in the X-direction. While forming separate sacrificial spacer layers in the opening, the second horizontal insulating layer 112 may be exposed in the first region R1 by an etch-back process. The exposed second horizontal insulating layer 112 may be selectively removed, and then, the upper and lower first horizontal insulating layers 111 may be removed. The horizontal insulating layer 110 may be removed by, e.g., a wet etching process. During the process of removing the first horizontal insulating layers 111, a portion of the gate dielectric layer 145 exposed in a region from which the second horizontal insulating layer 112 has been removed may also be removed. After forming the first horizontal conductive layer 102 by depositing a conductive material in a region from which the horizontal insulating layer 110 has been removed, the sacrificial spacer layers may be removed from the opening. By the above-described process, the first horizontal conductive layer 102 may be formed in the first region R1, and the horizontal insulating layer 110 may remain in the second region R2.

Next, the sacrificial insulating layers 118 may be selectively removed with respect to the interlayer insulating layers 120 using, e.g., wet etching. Accordingly, tunnel portions may be formed between the interlayer insulating layers 120. The gate electrodes 130 may be formed by filling the conductive material in the tunnel portions. The gate electrodes 130 may include a metal, polycrystalline silicon, or a metal silicide material.

Next, the separation region MS may be formed by filling the opening with the insulating material and forming the separation insulating layer 105.

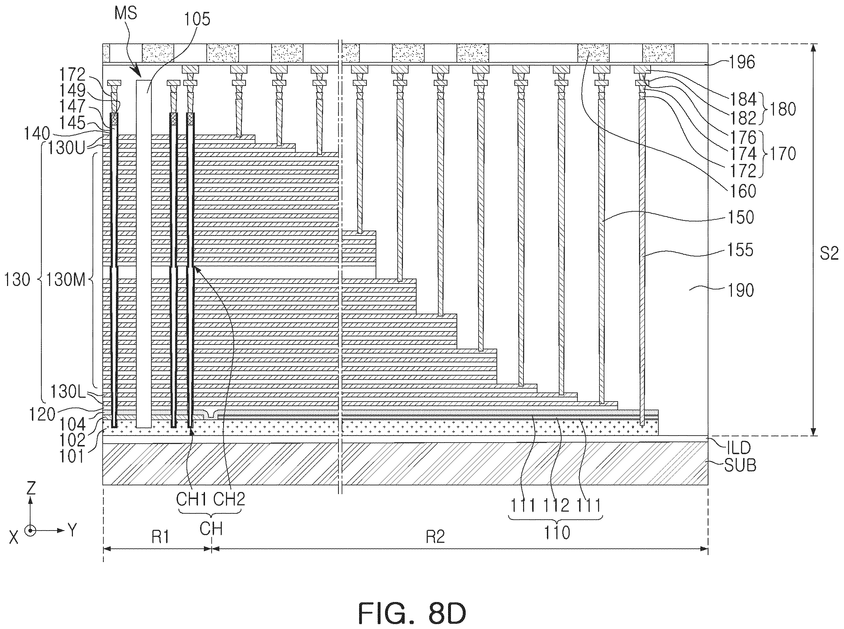

Referring to FIG. 8D, the second interconnection structure may be formed on the gate electrodes 130, and the second dummy pattern layers 160 may be formed.

In the second interconnection structure, the gate contacts 150 and the substrate contacts 155 may be formed by etching the cell region insulating layer 190 on the gate electrodes 130 and the plating layer 101 to form contact holes, and filling the contact holes with a conductive material. The cell contact plugs 170 may be formed by etching the cell region insulating layer 190 on the channel pads 149, the gate contacts 150 and the substrate contact 155, and depositing a conductive material. The cell interconnection lines 180 may be formed through a process of depositing and patterning the conductive material, or may be formed by partially forming the cell region insulating layer 190, patterning the cell region insulating layer 190 and depositing the conductive material. The upper protective layer 196 may be formed on the cell interconnection lines 180, e.g., the upper protective layer 196 may be formed to cover all the cell interconnection lines 180 and the entire cell region insulating layer 190 surrounding the cell interconnection lines 180.

The second dummy pattern layers 160 may be formed by patterning the cell region insulating layer 190 and depositing and planarizing an insulating material constituting the second dummy pattern layers 160 in a patterned region. For example, referring to FIG. 8D, an additional portion of the cell region insulating layer 190 may be formed on the upper protective layer 196, e.g., so the upper protective layer 196 may be vertically between the cell interconnection lines 180 and the additional portion of the cell region insulating layer 190, and the additional portion of the cell region insulating layer 190 may be patterned to form trenches for the second dummy pattern layers 160. The trenches in the additional portion of the cell region insulating layer 190 may be filled with the insulating material to form the second dummy pattern layers 160, e.g., upper surfaces of the additional portion of the cell region insulating layer 190 and the second dummy pattern layers 160 may be coplanar.

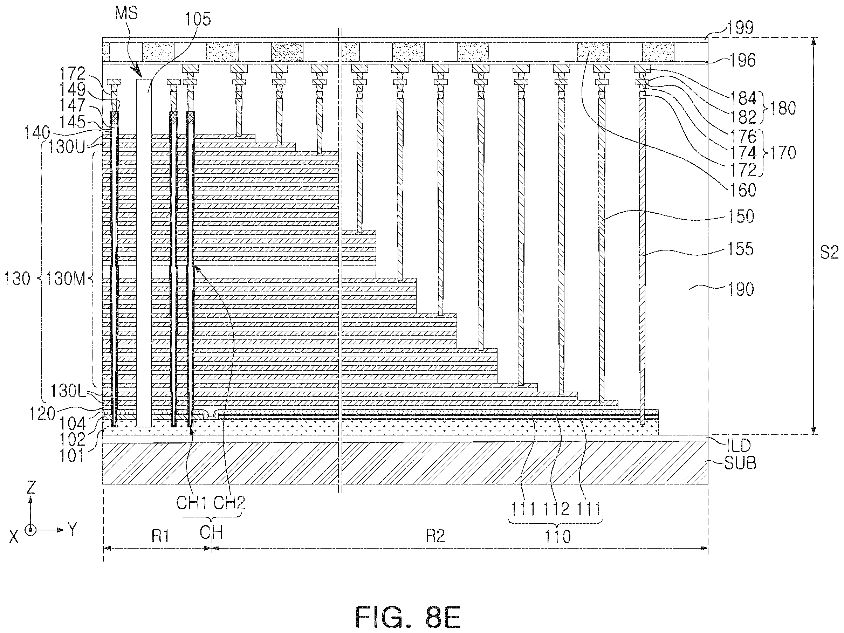

Referring to FIG. 8E, the second bonding insulating layer 199 may be formed on the second dummy pattern layers 160. The second bonding insulating layer 199 may be formed to cover upper surfaces of the second dummy pattern layers 160 and an of the additional portion of the cell region insulating layer 190.

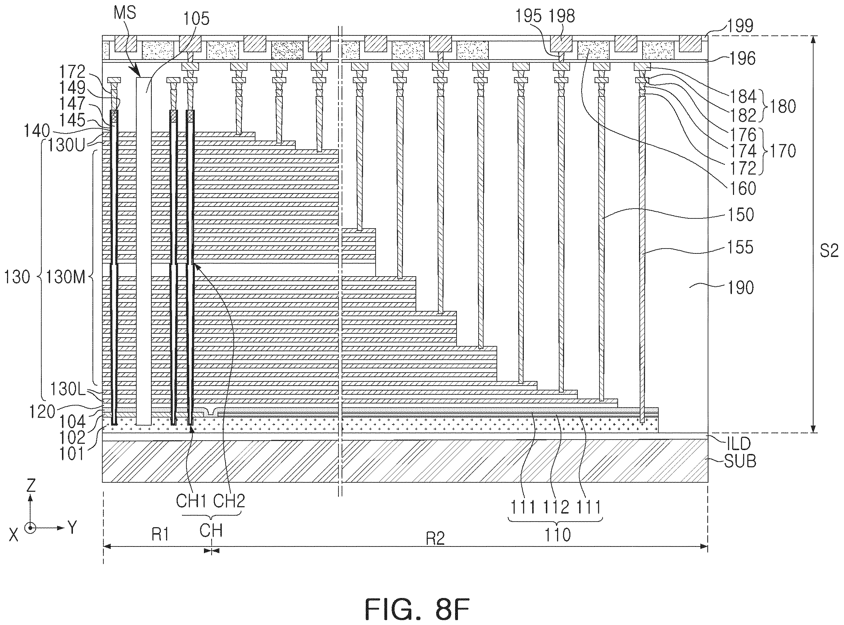

Referring to FIG. 8F, the second bonding vias 195 and the second metal bonding layers 198 constituting the second bonding structure may be formed.

First, the second bonding insulating layer 199 and the additional portion of the cell region insulating layer 190 may be partially removed, and a conductive material may be deposited to form the second bonding vias 195. Then, the second metal bonding layers 198 may be formed on the second bonding vias 195. In some example embodiments, the second bonding via 195 and the second metal bonding layer 198 disposed vertically may be formed integrally with each other. Upper surfaces of the second metal bonding layers 198 may be exposed from, e.g., and coplanar with, the upper surface of the second bonding insulating layer 199.

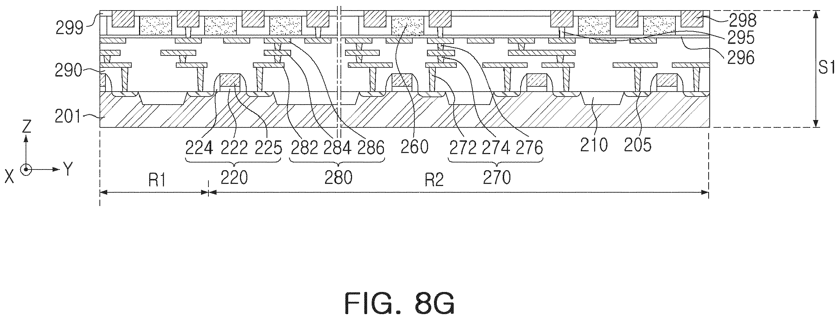

Referring to FIG. 8G, the first substrate structure S1, including the circuit elements 220, first interconnection structures, first bonding structures, and the first dummy pattern layers 260, may be formed on the substrate 201.

First, the element isolation layers 210 may be formed in the substrate 201, and the circuit gate dielectric layer 222 and the circuit gate electrode 225 may be sequentially formed over the substrate 201. The element isolation layers 210 may be formed by, e.g., a shallow trench isolation (STI) process. The circuit gate dielectric layer 222 may be formed of, e.g., silicon oxide, and the circuit gate electrode 225 may be formed of, e.g., at least one of polycrystalline silicon, metal silicide and a metal material. Next, the spacer layers 224 and the source/drain regions 205 may be formed on both sidewalls of the circuit gate dielectric layer 222 and the circuit gate electrode 225. Next, the source/drain regions 205 may be formed by performing an ion implantation process.

The circuit contact plugs 270 of the first interconnection structure may be formed by partially forming the peripheral region insulating layer 290, etching and removing a portion of the peripheral region insulating layer 290, and filling the conductive material therein. The circuit interconnection lines 280 of the first interconnection structure may be formed by, e.g., depositing the conductive material and then patterning the conductive material.

Next, similarly to the second substrate structure S2, after the lower protective layer 296 is formed over the circuit interconnection lines 280, the first dummy pattern layers 260 may be formed, and the first bonding insulating layer 299 may be formed. Next, the first bonding vias 295 and the first metal bonding layers 298 of the second bonding structure may be formed after partially removing the first bonding insulating layer 299 and the peripheral region insulating layer 290. In the present operation, the first substrate structure S1 may be prepared.

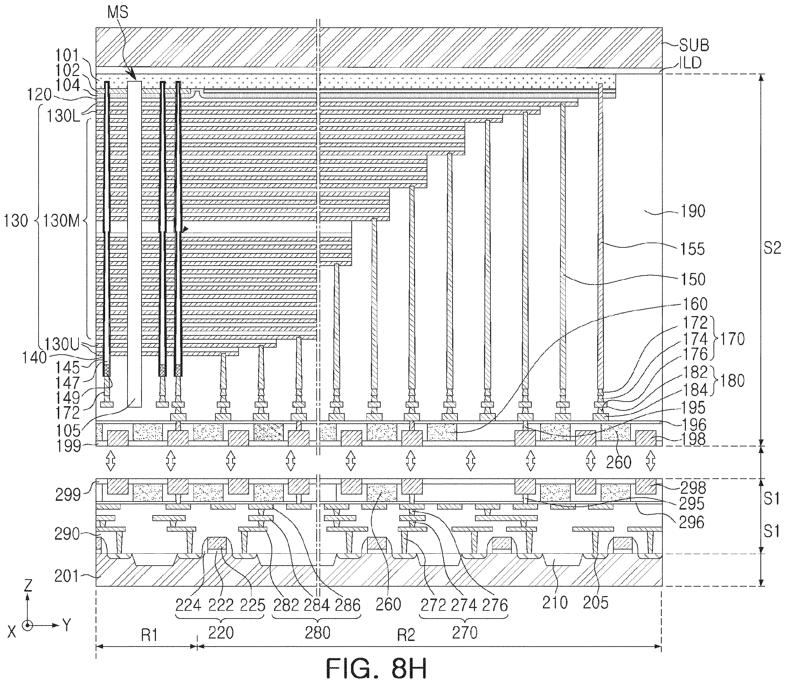

Referring to FIG. 8H, the first substrate structure S 1 and the second substrate structure S2 may be bonded to each other.

The first substrate structure S1 and the second substrate structure S2 may be bonded and connected to each other by annealing and/or pressurizing the first metal bonding layers 298 and the second metal bonding layers 198. At the same time, the first bonding insulating layer 299 and the second bonding insulating layer 199 may also be bonded. The second substrate structure S2 may be inverted over the first substrate structure S 1 so as to make the second metal bonding layers 198 face downwardly, thus bonding the first and second substrate structures S 1 and S2. In FIG. 8H, in order to facilitate understanding, the second substrate structure S2 is illustrated as being bonded in a form of a mirror image of the structure illustrated in FIG. 8G.

The first substrate structure S1 and the second substrate structure S2 may be directly bonded without interposing an adhesive, i.e., without a separate additional adhesive layer. According to example embodiments, in order to enhance bonding force before the bonding, a surface treatment process, e.g., a hydrogen plasma treatment, may be further performed on the upper surface of the first substrate structure S1 and the lower surface of the second substrate structure S2.

Since the second substrate structure S2 includes the second dummy pattern layers 160, warpage may be alleviated. Since the first substrate structure S1 also includes the first dummy pattern layers 260, the warpage of the second substrate structure S2 may be further offset. Accordingly, when the first substrate structure S1 and the second substrate structure S2 are bonded to each other in the present operation, the bonding may be performed without the occurrence of defects, e.g., cracks or voids, caused by the warpage.

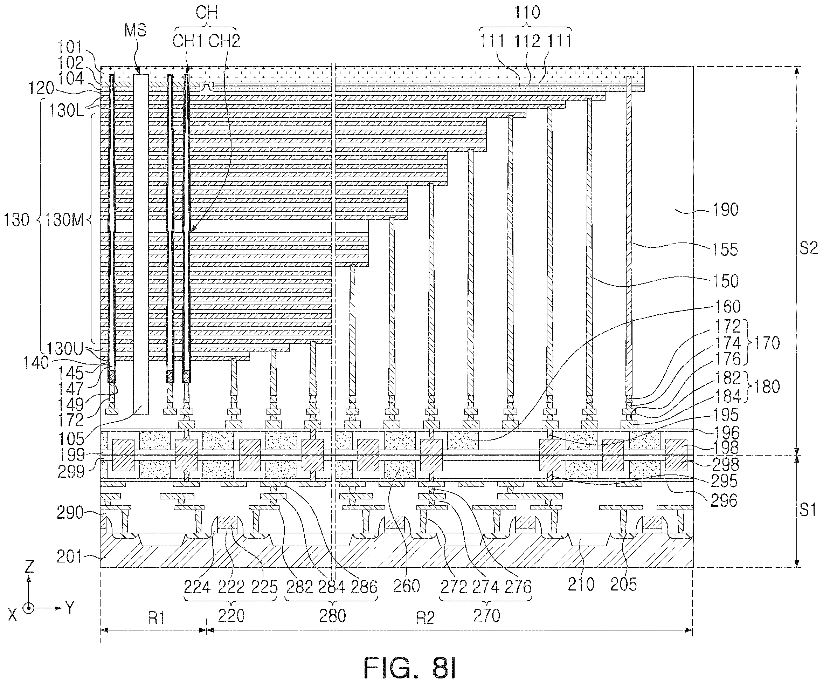

Referring to FIG. 8I, the base substrate SUB of the second substrate structure S2 may be removed from a bonding structure of the first and second substrate structures S1 and S2.

For example, a portion of an upper surface of the base substrate SUB may be removed by a polishing process, e.g., such as a grinding process, and the remaining portion may be removed by an etching process, e.g., wet etching. The total thickness of the semiconductor device may be minimized by removing the base substrate SUB of the second substrate structure S2. At least a portion of the intermediate insulating layer ILD may be removed when the base substrate SUB is removed.

In the case of a comparative example in which a layer for alleviating the warpage is formed on an upper surface of the second substrate structure S2, the layer may be removed along with the base substrate SUB in the present operation. Accordingly, there may be a problem in that it may be difficult to control the warpage again after the present operation. However, in the example embodiment, since the second dummy pattern layers 160 are formed between the second metal bonding layers 198, the warpage may be continuously controlled without increasing the overall thickness of the semiconductor device.

Next, referring to FIG. 1 together, the passivation layer 106 is formed on the upper surface of the plating layer 101, thereby finally manufacturing the semiconductor device 100 of FIG. 1.

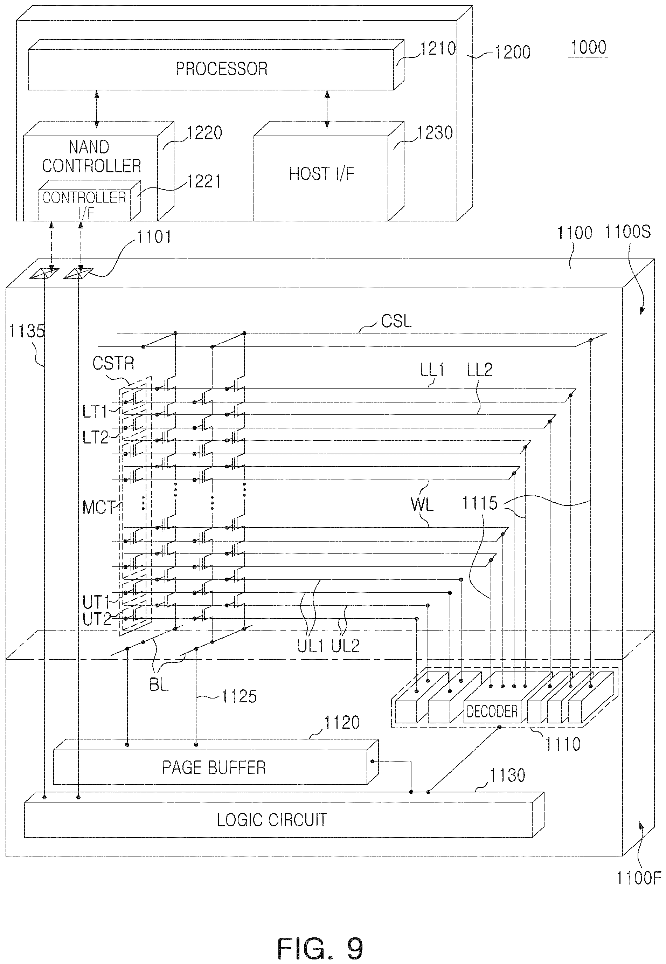

FIG. 9 is a view schematically illustrating a data storage system including a semiconductor device according to example embodiments of the present disclosure.

Referring to FIG. 9, a data storage system 1000 may include a semiconductor device 1100 and a controller 1200 electrically connected to the semiconductor device 1100. The data storage system 1000 may be a storage device including one or more semiconductor devices 1100 or an electronic device including the storage device. For example, the data storage system 1000 may be a solid state drive device including one or more semiconductor devices 1100, a universal serial bus (USB), a computing system, a medical device, or a communication device.

The semiconductor device 1100 may be a nonvolatile memory device, e.g., a NAND flash memory device described above with reference to FIGS. 1 to 7B. The semiconductor device 1100 may include a first structure 1100F and a second structure 1100S on the first structure 1100F. In example embodiments, the first structure 1100F may be disposed next to the second structure 1100S. The first structure 1100F may be a peripheral circuit structure including a decoder circuit 1110, a page buffer 1120, and a logic circuit 1130. The second structure 1100S may be a memory structure including a bit line BL, a common source line CSL, word lines WL, first and second gate upper lines UL1 and UL2, first and second gate lower lines LL1 and LL2, and memory cell strings CSTR between the bit line BL and the common source line CSL.

In the second structure 1 100S, each of the memory cell strings CSTR may include lower transistors LT1 and LT2 disposed adjacent to the common source line CSL, upper transistors UT1 and UT2 disposed adjacent to the bit line BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be variously modified according to example embodiments.

In example embodiments, the upper transistors UT1 and UT2 may include string select transistors, and the lower transistors LT1 and LT2 may include ground selection transistors. The gate lower lines LL1 and LL2 may be gate electrodes of the lower transistors LT1 and LT2, respectively. The word lines WL may be gate electrodes of the memory cell transistors MCT, and the gate upper lines UL1 and UL2 may be gate electrodes of the upper transistors UT1 and UT2, respectively. Here, the lower transistors, the upper transistors, the gate lower lines and the gate upper lines may be referred to as "lower" and "upper" based on a direction during a manufacturing process.

In example embodiments, the lower transistors LT1 and LT2 may include a lower erase control transistor LT1 and a ground selection transistor LT2 connected in series. The upper transistors UT1 and UT2 may include a string select transistor UT1 and an upper erase control transistor UT2 connected in series. At least one of the lower erase control transistor LT1 and the upper erase control transistor UT2 may be used for an erase operation of deleting data stored in the memory cell transistors MCT using a GIDL phenomenon.

The common source line CSL, the first and second gate lower lines LL1 and LL2, the word lines WL, and the first and second gate upper lines UL1 and UL2 may be electrically connected to the decoder circuit 1110 through first connections 1115 extending to the second structure 1100S in the first structure 1100F. The bit lines BL may be electrically connected to the page buffer 1120 through second connections 1125 extending from the first structure 1100F to the second structure 11005.

In the first structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through an input/output pad 1101 electrically connected to the logic circuit 1130. The input/output pad 1101 may be electrically connected to the logic circuit 1130 through an input/output connection wiring 1135 extending from the first structure 1100F to the second structure 1100S.

The controller 1200 may include a processor 1210, a NAND controller 1220, and a host interface 1230. According to example embodiments, the data storage system 1000 may include a plurality of semiconductor devices 1100, and in this case, the controller 1200 may control the plurality of semiconductor devices 1100.

The processor 1210 may control an overall operation of the data storage system 1000 including the controller 1200. The processor 1210 may operate according to a predetermined firmware, and may control the NAND controller 1220 to access the semiconductor device 1100. The NAND controller 1220 may include a NAND interface 1221 for processing communication with the semiconductor device 1100. Through the NAND interface 1221, a control command for controlling the semiconductor device 1100, data to be recorded in the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When receiving the control command from the external host through the host interface 1230, the processor 1210 may control the semiconductor device 1100 in response to the control command.

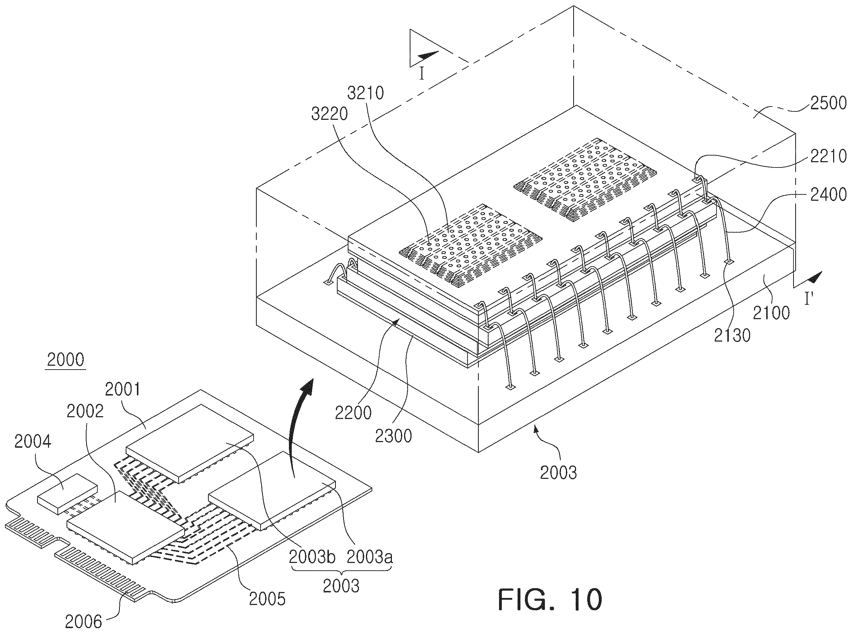

FIG. 10 is a perspective view schematically illustrating a data storage system including a semiconductor device according to an example embodiment.

Referring to FIG. 10, a data storage system 2000 according to an example embodiment of the present disclosure may include a main substrate 2001, and a controller 2002, one or more semiconductor packages 2003, and a dynamic random access memory (DRAM) 2004 mounted on the main substrate 2001. The semiconductor package 2003 and the DRAM 2004 may be connected to the controller 2002 by interconnection patterns 2005 formed on the main substrate 2001.

The main substrate 2001 may include a connector 2006 including a plurality of pins coupled to an external host. The number and arrangement of the plurality of pins in the connector 2006 may vary depending on a communication interface between the data storage system 2000 and the external host. In example embodiments, the data storage system 2000 may communicate with the external host according to any one of suitable interfaces, e.g., a Universal Serial Bus (USB), a Peripheral Component Interconnect Express (PCI-Express), Serial Advanced Technology Attachment (SATA), and M-Phy for Universal Flash Storage (UFS). In example embodiments, the data storage system 2000 may operate with power supplied from the external host through the connector 2006. The data storage system 2000 may further include a power management integrated circuit (PMIC) configured to distribute power supplied from the external host to the controller 2002 and the semiconductor package 2003.

The controller 2002 may record data in the semiconductor package 2003 or read data from the semiconductor package 2003, and may improve an operating speed of the data storage system 2000.

The DRAM 2004 may be a buffer memory for alleviating a speed difference between the semiconductor package 2003 which is a data storage space and the external host. The DRAM 2004 included in the data storage system 2000 may operate as a kind of cache memory, and may provide a space for temporarily storing data in a control operation for the semiconductor package 2003. When the data storage system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, the semiconductor chips 2200 on the package substrate 2100, adhesive layers 2300 disposed on lower surfaces of each of the semiconductor chips 2200, a connection structure 2400 configured to electrically connect the semiconductor chips 2200 and the package substrate 2100, and a molding layer 2500 configured to cover the semiconductor chips 2200 and the connection structure 2400 on the package substrate 2100.

The package substrate 2100 may be a printed circuit board including package upper pads 2130. Each of the semiconductor chips 2200 may include an input/output pad 2210. The input/output pad 2210 may correspond to the input/output pad 1101 of FIG. 9. Each of the semiconductor chips 2200 may include gate stacked structures 3210 and channel structures 3220. Each of the semiconductor chips 2200 may include the semiconductor device described above with reference to FIGS. 1 to 7B.

In example embodiments, the connection structure 2400 may be a bonding wire configured to electrically connect the input/output pad 2210 and the package upper pads 2130. Accordingly, in each of the first and second semiconductor packages 2003a and 2003b, the semiconductor chips 2200 may be electrically connected to each other by a bonding wire manner and may be electrically connected to the package upper pads 2130 of the package substrate 2100. According to example embodiments, in each of the first and second semiconductor packages 2003a and 2003b, the semiconductor chips 2200 may be electrically connected to each other by a connection structure including a through silicon via (TSV) instead of the connection structure 2400 having a bonding wire type.

In example embodiments, the controller 2002 and the semiconductor chips 2200 may be included in a single package. In an exemplary embodiment, the controller 2002 and the semiconductor chips 2200 may be mounted on a separate interposer substrate different from the main substrate 2001, and the controller 2002 and the semiconductor chips 2200 may be connected to each other by wiring formed on the interposer substrate.

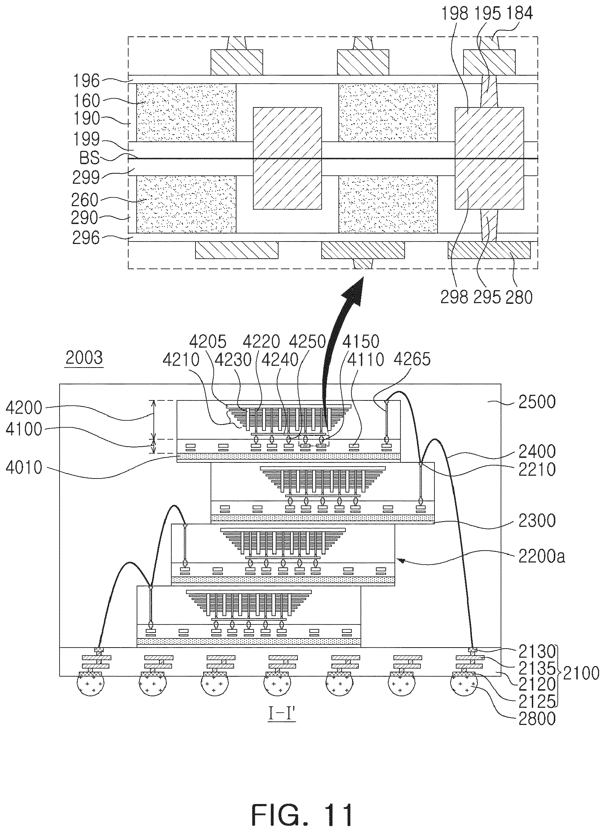

FIG. 11 is a cross-sectional view schematically illustrating a semiconductor package according to an example embodiment. FIG. 11 describes an example embodiment of the semiconductor package 2003 of FIG. 10, and conceptually illustrates a region in which the semiconductor package 2003 of FIG. 10 is cut along a cutting line I-I'.

Referring to FIG. 11, in the semiconductor package 2003, the package substrate 2100 may be a printed circuit board. The package substrate 2100 may include a package substrate body 2120, package upper pads 2130 disposed on an upper surface of the package substrate body 2120, and lower pads 2125 disposed on or exposed through a lower surface of the package substrate body 2120, and internal interconnections 2135 electrically connecting the upper pads 2130 and the lower pads 2125 in the package substrate body 2120. The upper pads 2130 may be electrically connected to the connection structures 2400. The lower pads 2125 may be connected to the interconnection patterns 2005 of the main substrate 2001 of the data storage system 2000, as shown in FIG. 10, through conductive connection parts 2800.

Each of the semiconductor chips 2200a may include a semiconductor substrate 4010, a first structure 4100 on the semiconductor substrate 4010, and a second structure 4200 bonded to the first structure 4100 by a wafer bonding manner on the first structure 4100.

The first structure 4100 may include a peripheral circuit region including a peripheral wiring 4110 and first bonding structures 4150. The second structure 4200 may include a common source line 4205, a gate stacked structure 4210 disposed between the common source line 4205 and the first structure 4100, channel structures 4220 and a separation region 4230 penetrating through the gate stacked structure 4210, and second bonding structures 4250 electrically connected to the word lines WL (see FIG. 9) of the gate stacked structure 4210 and the memory channel structures 4220, respectively. For example, the second bonding structures 4250 may be electrically connected to the memory channel structures 4220 and word lines, respectively, through bit lines 4240 electrically connected to the memory channel structures 4220 and the gate contacts 150 (see FIG. 1) electrically connected to the word lines. The first bonding structures 4150 of the first structure 4100 and the second bonding structures 4250 of the second structure 4200 may be in contact with and bonded to contacting each other. Portions in which the first bonding structures 4150 and the second bonding structures 4250 are bonded may be formed of, for example, copper (Cu).

As illustrated in the enlarged view, in the second structure 4200, each of the semiconductor chips 2200a may include the first dummy pattern layers 260 and/or the second dummy pattern layers 160 disposed adjacent to the bonding surface BS and made of an insulating material. Each of the semiconductor chips 2200a may further include the input/output pad 2210 and an input/output connection 4265 disposed on a lower portion of the input/output pad 2210. The input/output connection 4265 may be electrically connected to a portion of the gate stacked structures 4210.

The semiconductor chips 2200a may be electrically connected to each other by the connection structures 2400 (see FIG. 10) in the form of bonding wires. However, in example embodiments, semiconductor chips in one semiconductor package, such as the semiconductor chips 2200a, may be electrically connected to each other by a connection structure including a through silicon via (TSV).

By way of summation and review, an aspect of the present disclosure is to provide semiconductor devices having improved reliability. An aspect of the present disclosure is also to provide data storage systems including semiconductor devices having improved reliability. That is, in a structure in which two or more substrate structures are bonded to each other, semiconductor devices with improved reliability and data storage systems including the same may be provided by disposing dummy pattern layers including an insulating material between metal bonding layers.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A semiconductor device, comprising:
a first substrate structure (S1) including a substrate (201), circuit elements (220) on the substrate (201), a first interconnection structure (270, 280) on the circuit elements (220), and first metal bonding layers (298) on the first interconnection structure (270, 280); and
a second substrate structure (S2) connected to the first substrate structure (S1) on the first substrate structure (S1), the second substrate structure (S2) including:
a plating layer (101);
gate electrodes (130) stacked and spaced apart from each other in a first direction (Z) perpendicular to a lower surface of the plating layer (101) below the plating layer (101);
channel structures (CH) penetrating through the gate electrodes (130) and extending in the first direction (Z), each of the channel structures (CH) including a channel layer (140);
a separation region (MS) penetrating through the gate electrodes (130) and extending in a second direction (X) perpendicular to the first direction (Z);
a second interconnection structure (150, 155, 170, 180) below the gate electrodes (130) and the channel structures (CH);
second metal bonding layers (198) below the second interconnection structure (150, 155, 170, 180) and connected to the first metal bonding layers (298); and
dummy pattern layers (160; 160a; 160b) between the second metal bonding layers (198), the dummy pattern layers (160; 160a; 160b) extending in the second direction (X) and including an insulating material.

2. The semiconductor device as claimed in claim 1, wherein each of the second metal bonding layers (198) has a first thickness (T3), and each of the dummy pattern layers (160; 160a; 160b) has a second thickness (T4; T4') greater than the first thickness (T3).

3. The semiconductor device as claimed in claim 1 or 2, wherein the dummy pattern layers (160; 160a; 160b) overlap at least a portion of the second metal bonding layers (198) in a horizontal direction parallel to a bottom of the substrate (201).

4. The semiconductor device as claimed in any one of claims 1 to 3, wherein lower surfaces of the dummy pattern layers (160; 160a; 160b) are higher than lower surfaces of the second metal bonding layers (198) relative to a bottom of the substrate (201).

5. The semiconductor device as claimed in any one of claims 1 to 4, wherein:
the first substrate structure (S1) further includes a first bonding insulating layer (299) surrounding the first metal bonding layers (298), and
the second substrate structure (S2) further includes a second bonding insulating layer (199) surrounding the second metal bonding layers (198), the second bonding insulating layer (199) being connected to the first bonding insulating layer (299) and covering lower surfaces of the dummy pattern layers (160; 160a; 160b).

6. The semiconductor device as claimed in any one of claims 1 to 5, wherein:
the second substrate structure (S2) further includes an upper protective layer (196) covering a lower surface of the second interconnection structure (150, 155, 170, 180), and
upper surfaces of the dummy pattern layers (160; 160a) are in contact with the upper protective layer (196).

7. The semiconductor device as claimed in any one of claims 1 to 6, wherein the dummy pattern layers (160; 160a; 160b) include a different material from a material of the gate electrodes (130) and a material of the second metal bonding layers (198).

8. The semiconductor device as claimed in any one of claims 1 to 7, wherein the dummy pattern layers (160; 160a; 160b) include at least one of SiN, SiON, SiCN, SiOC, SiOCN, and SiO.

9. The semiconductor device as claimed in any one of claims 1 to 8, wherein the dummy pattern layers (160; 160a; 160b) have a width (W1; W1') of about 200 nm to about 1000 nm in a third direction (Y) perpendicular to the second direction (X).

10. The semiconductor device as claimed in any one of claims 1 to 9, wherein at least one of the dummy pattern layers (160a) extends onto an upper surface of at least one of the second metal bonding layers (198) and is in contact with the upper surface of the at least one of the second metal bonding layers (198).

11. The semiconductor device as claimed in any one of claims 1 to 10, wherein upper surfaces of the dummy pattern layers (160b) are higher than a lower surface of the second interconnection structure (150, 155, 170, 180) relative to a bottom of the substrate (201).

12. The semiconductor device as claimed in any one of claims 1 to 11, wherein the first substrate structure (S1) further includes lower dummy pattern layers (260; 260a; 260b) between the first metal bonding layers (298), the lower dummy pattern layers (260; 260a; 260b) extending in the second direction (X) and including an insulating material.

13. The semiconductor device as claimed in any one of claims 1 to 12, wherein:
the second substrate structure (S2) further includes bonding vias (195) connected to the second metal bonding layers (198) on the second metal bonding layers (198), and
the dummy pattern layers (160; 160a; 160b) overlap at least a portion of the bonding vias (195) in a horizontal direction parallel to a bottom of the substrate (201).

14. The semiconductor device as claimed in any one of claims 1 to 13, wherein the dummy pattern layers (160; 160a; 160b) include a different material from a material of the first metal bonding layers (298) and a material of the second metal bonding layers (198).

15. A data storage system, comprising:
a semiconductor device of any one of claims 1 to 14, the semiconductor device further including an input/output pad (1101; 2210) electrically connected to the circuit elements (220); and
a controller (1200; 2002) electrically connected to the semiconductor device through the input/output pad (1101; 2210) and configured to control the semiconductor device.
